Europäisches Patentamt

European Patent Office

Office européen des brevets

(10)

(11) Numéro de publication: **0 214 207**
**B1**

(12) **FASCICULE DE BREVET EUROPEEN**

(45) Date de publication du fascicule du brevet: **23.05.90**

(51) Int. Cl.⁵: **H 01 L 21/203, C 30 B 23/02**

(21) Numéro de dépôt: **86901409.2**

(22) Date de dépôt: **19.02.86**

(86) Numéro de dépôt international:
**PCT/FR86/00048**

(87) Numéro de publication internationale:
**WO 86/05319 12.09.86 Gazette 86/20**

(54) **PROCEDE ET DISPOSITIF DE DEPOT PAR CROISSANCE EPITAXIALE D'UN MATERIAU DOPE.**

(30) Priorité: **28.02.85 FR 8502976**

(43) Date de publication de la demande:
**18.03.87 Bulletin 87/12**

(45) Mention de la délivrance du brevet:
**23.05.90 Bulletin 90/21**

(84) Etats contractants désignés:
**DE GB IT NL**

(56) Documents cités:
**EP-A-0 110 468**
**US-A-4 071 383**
**US-A-4 086 108**
**US-A-4 411 728**

**JOURNAL OF APPLIED PHYSICS, vol.51, no.5, mai 1980, New York, US, N. SUGIURA:"Silicon molecular beam epitaxy with antimony ion doping", pages 2630-2633**
**PATENTS ABSTRACTS OF JAPAN, vol.6, no.243, 2 december 1982, page 1121 & JP-A-57143820**
**PATENTS ABSTRACTS OF JAPAN, vol.7, no.229, 12 octobre 1983, page 1374 & JP-A-58119630**

(73) Titulaire: **ARNAUD D'AVITAYA, François**
**17, avenue du Vercors**
**F-38240 Meylan (FR)**
(73) Titulaire: **CAMPIDELLI, Yves**
**8, rue Bayard**
**F-38000 Grenoble (FR)**

(72) Inventeur: **ARNAUD D'AVITAYA, François**
**17, avenue du Vercors**
**F-38240 Meylan (FR)**
Inventeur: **CAMPIDELLI, Yves**
**8, rue Bayard**
**F-38000 Grenoble (FR)**

(74) Mandataire: **Mongrédien, André et al**
**c/o BREVATOME 25, rue de Ponthieu**
**F-75008 Paris (FR)**

Courier Press, Leamington Spa, England.

## Description

La présente invention a pour object un procédé de dépôt croissance épitaxiale d'un matériau dopé.

Elle trouve un application en particulier dans la réalisation de composants électroniques ou micro-électroniques formés du plusieurs couches minces notamment semiconductrices, superposées et dopées différemment. Les matériaux semiconducteurs essentiellement utilisés sont le silicium ou les matériaux III—V tels que l'arséniure de gallium. Comme composants électroniques, l'invention permet notamment de réaliser les diodes hyperfréquences, des lasers hétéro-jonctions et des transistors très rapides tels que des transistors SMS (Silicium Métal Silicium) ou des transistors à base perméable (base en forme de grille).

Les couches minces semiconductrices sont généralement réalisées par croissance épitaxiale sur un substrat semiconducteur monocristallin. Les différentes techniques d'épitaxie actuellement connues sont l'épitaxie en phase liquide (LPE), l'épitaxie chimique en phase vapeur (CVD) et l'épitaxie par jets moléculaires (MBE).

Parmi ces différentes techniques d'épitaxie, l'épitaxie par jets moléculaires présente des performances intrinsèquement plus élevées, notamment pour l'obtention de couches très minces de quelques nanomètres, de surface parfaitement plane et d'interface très abrupte. Un procédé et un dispositif d'épitaxie par jets moléculaires sont notamment décrits dans un article de Y.OTA paru dans J. Appl. Phys. 51(2) de février 1980 pages 1102—1110 intitulé "Silicon molecular beam epitaxy with simultaneous ion implant doping".

Dans cette technique, on forme, dans une enceinte étanche, des jets ou flux moléculaires du métariau à épitaxier, par exemple le silicium, et on soumet le substrat chauffé à l'action de ces jets moléculaires ainsi qu'à l'action d'un faisceau de particules dopantes.

La température de chauffage du substrat est relativement faible (600—850°C) comparativement aux autres procédés de dépôt et notamment au procédé de dépôt chimique en phase vapeur (1000—1200°C). A cette faible température, il n'existe pratiquement pas de diffusion des particules dopantes et par conséquent, il est possible de réaliser des couches superposées dopées différemment avec un profil de dopage extrêmement abrupt, profil indispensable pour les composants rapides.

Cependant, cette technique de dépôt pose un certain nombre de problèmes notamment en ce qui concerne le dopage des couches semiconductrices. En effet, pour certaines particules dopantes, comme par exemple d'arsenic, de phosphore ou d'antimoine, etc, utilisés pour un dopage de type p du silicium, il se, passe un phénomène très gênant. En particulier, le matériau dopant est évaporé sous forme de molécules de type $X_4$ ($As_4$, $P_4$ ...) et à la température relativement faible du chauffage du substrat (600 à 850°C), il existe une tension de vapeur du gaz dopant ayant pour effet qu'une grande majorité de molécules dopantes, venant toucher la surface de la couche semiconductrice en croissance épitaxiale, ne s'intègre pas à cette couche mais repart dans le gaz dopant.

On a pu ainsi déterminer un "coefficient de collage" qui est dans la pratique de l'ordre de $10^{-4}$, c'est-à-dire qu'un atome de dopant s'intègre à la couche en croissance épitaxiale pour 10 000 atomes, situés à sa surface. Ce faible "coefficient de collage" nécessite d'injecter dans l'enceinte d'épitaxie, dans laquelle un vide très poussé est réalisé, une grande quantité de gaz dopant, ce qui est incompatible avec la nécessité de maintenir un ultravide.

L'une des solutions actuellement proposées pour augmenter le "coefficient de collage" sur le substrat à épitaxier consiste à polariser ce substrat. Cette polarisation du substrat permet d'attirer les particules dopantes ionisées venant alors frapper la surface du substrat. Malheureusement, ce bombardement de particules ionisées entraîne un endommagement de la couche épitaxiée en créant de nombreux défauts cristallins dans cette couche, pouvant entraîner la formation d'une couche pratiquement amorphe (effet de "sputtering" en terminologie anglo-saxonne ou de "pulvérisation cathodique").

Du document US—A—4 086 108, est connu un procédé de dépôt par croissance épitaxiale sur la surface d'un substrat d'une couche de matériau dopé consistant à soumettre la surface du substrat chauffé à l'action d'un jet moléculaire et à cellui d'un faisceau de particules dopants ionisies. Une partie au moins de cette surface est irradiée avec un faisceau d'èlectrons d'intensité donnée qui neutralise alors électriquement es particules dans les parties du substrat où un dopage n'est pas souhaité.

La présente invention a par contre pour objet un procédé de dépôt par croissance épitaxiale d'un matériau dopé permettant l'obtention, selon la technique d'épitaxie par jets moléculaires, d'une couche épitaxiée dopée dont le dopant a un "coefficient de collage" voisin de 1, sans pour autant entraîner la création de défauts cristallins dans cette couche.

De façon plus précise, l'invention a pour objet un procédé de dépôt, par croissance épitaxiale sur la surface d'un substrat, d'une couche d'un matériau dopé, consistant à chauffer le substrat dans une enceinte étanche et à soumettre la surface de ce substrat à l'action d'un flux moléculaire dudit matériau et à l'action d'un faisceau de particules dopantes, caractérisé en ce que, simultanément, on irradie au moins une partie de la surface du substrat avec un faisceau d'électrons d'intensité donnée de façon à augmenter corrilativement la quantité de particules dopantes de la couche à épitaxier dans cette partie par augmentation du coefficient de collage du dopant.

Ce procédé permet, bien que les phénomènes physico-chimiques qui se passent à la surface du substrat ne soient pas parfaitement connus, d'obtenir une couche épitaxiée de très bonne qualité et dopée de façon efficace étant donné que le gaz dopant a alors un "coefficient de collage" voisin de 1. Le bombardement électronique de la surface du substrat provoque alors un accroissement de la concentration du dopage de la couche épitaxiée dans la proportion de 1 à 10 000.

Par ailleurs, ce bombardement électronique permet d'abaisser la température de chauffage du substrat. En particulier, le dépôt d'une couche de silicium dopé peut être réalisé en ne chauffant le substrat, notamment en silicium, qu'a une température allant de 600° à 800°C au lieu d'un chauffage comprise entre 800° et 850°C.

Les avantages que procure l'invention sont liés à l'emploi d'un faisceau d'électrons. En effet, des études faites par les inventeurs on montré que le bombardement du substrat avec un faisceau lumineux par exemple un faisceau laser, ne permet pas d'obtenir les mêmes résultats.

Le procédé selon l'invention permet de déposer des couches semiconductrices dopées. Il s'applique avantageusement au dépôt de couches de silicium de type P dopées par exemple à l'arsenic, au phosphore, ou à l'antimoine, ou de type N dopées notamment au bore ainsi qu'au dépôt de couches en matériau III—V, tel que l'arsénium de gallium, le phosphure d'indium ou de gallium, dopé avec des éléments métalliques par exemple le zinc, le béryllium ou l'étain.

Ces couches sont de préférence déposées sur un substrat semiconducteur monocristallin. L'une des principales conditions de dépôt par épitaxie d'une couche monocristalline quelconque sur un substrat monocristallin quelconque est que la maille du substrat présente des dimensions et une géométrie voisines de celle de la couche épitaxiée.

Selon un mode préféré de mise en oeuvre du procédé de l'invention, on forme le flux moléculaire du matériau constituant la couche à épitaxier par irradiation d'une cible de ce matériau avec un faisceau d'électrons.

Le procédé selon l'invention permet avantageusement de réaliser sur un même substrat plusieurs couches superposées d'un même matériau, notamment monocristallin, dopées différemment par exemple avec une transition extrêmement abrupte de la concentration en dopant, (de quelques couches atomiques), simplement en modifiant brusquement l'intensité du faisceau d'électrons, lors de la croissance épitaxiale des couches. On peut aussi définir avantageusement sur le substrat des zones géométriques très précises dont la concentration en particules dopants est différente, en envoyant le faisceau d'électrons uniquement dans ces zones.

Par des couches dopées différemment, il faut aussi bien comprendre des couches de type N ou P, en signe + ou − que des couches de même type dont la concentration en dopant va de $10^{15}$ à $10^{19}$ atomes/cm$^2$.

Le dispositif de mise en oeuvre comprend, dans une enceinte étranche:

des moyens pour supporter le substrat,

des moyens pour chauffer le substrat,

des moyens pour supporter au moins une cible dudit matériau,

des moyens de chauffage de ladite cible pour former un flux moléculaire dudit matériau,

des moyens pour former au moins un faisceau de particules dopantes, et

une source d'électrons servant à irradier au moins un partie de la surface du substrat.

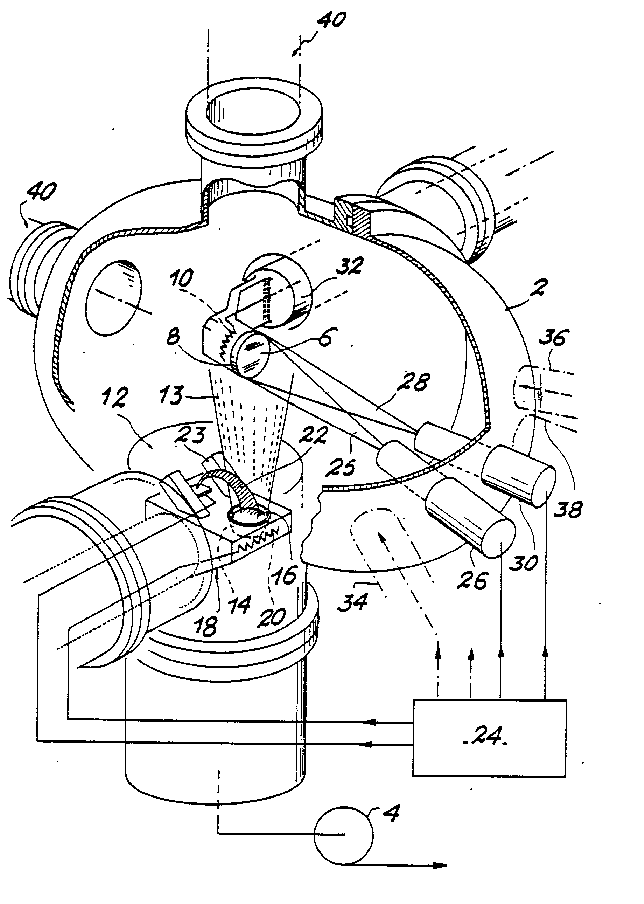

D'autres caractéristiques et avantages de l'invention ressortiront mieux de la description qui va suivre, donée à titre illustratif et non limitatif en référence à l'unique figure qui représente schématiquement, en perspective, un dispositif d'épitaxie permettant la mise en oeuvre du procédé de l'invention.

Le procédé selon l'invention consiste tout d'abord à créer dans une enceinte étanche 2 un vide très poussé, par exemple de $5.10^{-11}$ torr $(6,7.10^{-9}$Pa). A cet effet, l'enceinte 2 est reliée à une pompe à vide 4 de type classique. Un substrat 6 sur lequel vont s'épitaxier lesdites couches à déposer, par exemple un monocristal de silicium, est placé à l'intérieur de l'enceinte 2 sur un support 8 prévu à cet effet. Des moyens de chauffage 10, tels qu'un filament chauffant logé à l'intérieur du support 8, permettent d'élever la température du substrat 6. Pour un substrat en silicium monocristallin, la température de chauffage est comprise entre 600° et 800°C. Cette température est inférieure à celle utilisée dans l'art antérieur.

Dans l'enceinte étanche 2 est placé un dispositif d'évaporation 12 permettant de créer des jets ou un flux moléculaires 13 du matériau devant constituer la couche ou les couches á épitaxier sur le substrat 6. Ce dispositif 12 d'évaporation 12 a notamment fait l'objet d'un brevet américain 4 303 694.

De façon simplifiée, ce dispositif 12 comporte un creuset 14, en matériau réfractaire contenant le matériau 16 devant constituer la couche à épitaxier, logé dans un support 18 équipé de moyens de chauffage 20 du creuset 14. Un faisceau d'électrons 22, émis par une source de type connu logée par exemple dans le support 18, est envoyé, à l'aide d'un système de déviation approprié 23 tel que des aimants, sur le matériau 16 à épitaxier. Des moyens 24 permettent notamment de commander le chauffage du creuset 14 (température, durée) ainsi que le bombardement électronique 22 (temps d'irradiation, intensité, positionnement du faisceau).

Afin d'obtenir une couche épitaxiée dopée, on crée dans l'enceinte 2 un faisceau de particules dopantes 25 émis par une source 26 telle qu'une cellule de Krudtsen bien connue de l'homme de l'art.

Afin d'obtenir un dopage efficace de la couche épitaxiée et en particulier un "coefficient de collage" voisin de 1, on soumet conformément à l'invention tout ou partie de la surface du substrat 6, lors de la croissance épitaxiale, à l'action d'un faisceau d'électrons 28, engendré par un canon à électrons 30, bien connu de l'homme du métier.

Les moyens 24 permettent aussi si nécessaire de modifier brusquement l'intensité du faisceau d'électrons 28, voire à l'annuler complétement, lors de la croissance épitaxiale de la couche afin de modifier de façon très précisé la concentration de dopants dans la couche épitaxiée. De plus, en ne soumettant que certaines parties de la surface du substrat 6 à l'action du faisceau d'électrons 28, on peut définir de façon très précise des zones géométriques dont la concentration en dopants varie.

Par ailleurs, afin de réaliser sur un même substrat 6 plusieurs couches superposées d'un même matériau, dopées avec des dopants différents, d'autres sources de particules dopantes telles que 34, 36 et 38 peuvent être prévues à l'intérieur de l'enceinte étanche 2. La commande des différentes sources de dopants est assurée par exemple par les moyens 24.

Des moyens de commande 32 du support du substrat 6 permettent d'orienter la surface du substrat, sur laquelle vont s'épitaxier la ou les différentes couches dopées, par rapport au faisceau d'électrons 28, aux faisceaux de particules dopantes tels que 25 et au flux moléculaire 13.

Sur l'enceinte 2, différents moyens de mesure et d'analyse 40 permettent de contrôler le dèpôt des couches ainsi que leur dopage.

Le procédé selon l'inventier est applicable avantageusement au dépôt, sur un substrat de silicium monocristallin, de couches de silicium monocristallin dopées notamment à l'arsenic, au phosphore ou à l'antimoine dans le cas de couches de type N, ou bien dopées au bore dans le cas de couches de type P.

Avec le procédé selon l'invention, il est possible d'obtenir une couche épitaxiée de silicium monocristallin dopée à l'antimoine avec une concentration de $3.10^{19}$ atomes/cm$^3$, en utilisant un faisceau d'électrons 28 ayant une energie de 100V et un courant électronique de 10 à 100 µA/cm$^2$. Les particules dopantes d'antimoine sont obtenues en chauffant une cellule de Krudtsen à 300°C et le flux moléculaire de silicium est obtenu avec une vitesse d'évaporation de 1 µm/h. La température du substrat en silicium monoristallin est de 730°C.

La suppression du faisceau d'électrons 28 conduit, toutes choses égales par ailleurs, à un dopage de $2.10^{17}$ atomes/cm$^3$ au lieu de $3.10^{19}$ atomes/cm$^3$.

La description donnée précédemment n'a bien entendu été donnée qu'à titre explicatif et non limitatif, toutes modifications, sans pour autant sortir du cadre de l'invention, pouvant être envisagées.

En particulier, le substrat d'épitaxie et les couches à épitaxier peuvent être réalisés en un autre matériau que le silicium monocristallin. Le substrat et les couches épitaxiées peuvent notamment être réalisés en arséniure de gallium, en phosphure d'indium ou de gallium.

Par ailleurs, on peut remplacer la cellule de Krudtsen, constituant la source de particules dopantes, par une simple cible de ce matériau soumise à un bombardement électronique.

## Revendications

1. Procédé de dépôt, par croissance épitaxiale sur la surface d'un substrat (6), d'une couche d'un matériau (16) dopé, consistant à chauffer le substrat (6) dans une enceinte étanche (2), et à soumettre la surface de ce substrat à l'action d'un flux moléculaire (13) dudit matériau (16) et à l'action d'un faisceau de particules dopantes (25), caractérisé en ce que, simultanément, on irradie au moins une partie de la surface du substrat (6) avec un faisceau d'électrons (28) d'intensité donnée de façon à augmenter correlativement la quantité de particules dopantes de la couche à épitaxier dans cette partie par augmentation du coefficient de collage du dopant.

2. Procédé de dépôt selon la revendication 1, caractérisé en ce que les particules dopantes sont obtenues sous forme de molécules de type $X_4$ par évaporation d'un matériau dopant.

3. Procédé de dépôt selon la revendication 1 ou 2, caractérisé en ce que le matériau (16) est un matériau semiconducteur.

4. Procédé de dépôt selon l'une quelconque des revendications 1 à 3, caractérisé en ce que le matériau (16) est réalisé en silicium ou en un matériau III—V.

5. Procédé de dépôt selon la revendication 4, caractérisé en ce que les particules dopantes (25) sont des particules d'arsenic, de phosphore, d'antimoine ou de bore pour un matériau en silicium.

6. Procédé de dépôt selon l'une quelconque des revendications 1 à 5, caractérisé en ce que le substrat (6) est un matériau semiconducteur monocristallin.

7. Procédé de dépôt selon l'une quelconque des revendications 1 à 6, caractérisé en ce que le substrat (6) est réalisé en silicium ou en un matériau III—V.

8. Procédé de dépôt selon l'une quelconque des revendications 1 à 7, caractérisé en ce que l'on chauffe le substrat (6) à une température comprise entre 600°C et 800°C.

9. Procédé de dépôt selon l'une quelconque des revendications 1 à 8, caractérisé en ce que l'on forme le flux moléculaire (13) dudit matériau (16) par irradiation d'une cible de ce matériau avec un faisceau d'électrons (22).

10. Procédé de dépôt selon l'une quelconque des revendications 1 à 9, de plusieurs couches d'un même matériau dopées différemment, caractérisé en ce que l'on modifie brusquement l'intensité du faisceau d'électrons (28) et/ou le faisceau de particules dopantes.

## Patentansprüche

1. Verfahren zur Abscheidung einer Schicht aus einem dotierten Material (6) durch epitaxiales Aufwachsenlassen auf die Oberfläche eines Substrats (6), das darin besteht, daß das Substrat (6) in einem dichten Behälter (2) erwärmt wird und die Oberfläche dieses Substrats der Wirkung eines Molekularflusses (13) des Materials (16) und der Wirkung eines Bündels von Dotierungsmittelteilchen (25) ausgesetzt wird, dadurch gekennzeichnet, daß gleichzeitig mindestens ein Teil der Oberfläche des Substrats (6) mit einem Elektronenstrahlbündel (28) mit gegebener Intensität so bestrahlt wird, daß die Menge der Dotierungsmittelteilchen der epitaxial aufzubringenden Schicht in diesem Teil korrelativ erhöht wird durch Erhöhung des Haftungskoeffizienten des Dotierungsmittels.

2. Verfahren zur Abscheidung nach Anspruch 1, dadurch gekennzeichnet, daß die Dotierungsmittelteilchen in Form von Molekülen vom Typ $X_4$ vorliegen, die durch Verdampften des Dotierungsmaterials erhalten wurden.

3. Verfahren zur Abscheidung nach Anspruch 1 oder 2, dadurch gekennzeichnet, daß es sich bei dem Material (16) um ein Halbleitermaterial handelt.

4. Verfahren zur Abscheidung nach einem der Ansprüche 1 bis 3, dadurch gekennzeichnet, daß das Material (16) aus Silicium oder aus einem Material III—V besteht.

5. Verfahren zur Abscheidung nach Anspruch 4, dadurch gekennzeichnet, daß es sich bei den Dotierungsmittelteilchen (25) um Teilchen aus Arsen, Phosphor, Antimon oder Bor für ein Material aus Silicium handelt.

6. Verfahren zur Abscheidung nach einem der Ansprüche 1 bis 5, dadurch gekennzeichnet, daß es sich bei dem Substrat (6) um ein monokristallines Halbleitermaterial handelt.

7. Verfahren zur Abscheidung nach einem der Ansprüche 1 bis 6, dadurch gekennzeichnet, daß das Substrat (6) aus Silicium oder aus einem Material III—V besteht.

8. Verfahren zur Abscheidung nach einem der Ansprüche 1 bis 7, dadurch gekennzeichnet, daß man das Substrat (6) auf eine Temperatur zwischen 600 und 800°C erwärmt.

9. Verfahren zur Abscheidung nach einem der Ansprüche 1 bis 8, dadurch gekennzeichnet, daß man den Molekularfluß (13) des Materials (16) durch Bestrahlung einer Scheibe (Target) aus diesem Material mit einem Elektronenstrahlbündel (22) erzeugt.

10. Verfahren zur Abscheidung von mehreren Schichten aus dem gleichen Material, die unterschiedlich dotiert sind, nach einem der Ansprüche 1 bis 9, dadurch gekennzeichnet, daß man die Intensität des Elektronenstrahlbündels (28) und/oder des Bündels aus den Dotierungsmittelteilchen scharf modifiziert.

**Claims**

1. Process for the deposition by epitaxial growth on to the surface of a substrate (6) of a layer of doped material (16), which consists of heating the substrate (6) in a tight enclosure (2) and subjecting the surface of said substrate to the action of a molecular flux (13) of said material (16) and to the action of a beam of doping particles (25), characterized in that, simultaneously, at least part of the surface of the substrate (6) is irradiated with an electron beam (28) of given intensity, so as to correlatively increase the quantity of doping particles in the layer to be epitaxied in said part by increasing the bonding coefficient of the doping agent.

2. Deposition process according to claim 1, characterized in that the doping particles are obtained in the form of $X_4$ molecules by evaporating a doping material.

3. Deposition process according to claims 1 or 2, characterized in that the material (16) is a semiconductor material.

4. Deposition process according to any one of the claims 1 to 3, characterized in that the material (16) is formed from silicon or a III—V material.

5. Deposition process according to claim 4, characterized in that the doping particles (25) are particles of arsenic, phosphorus, antimony or boron for a silicon material.

6. Deposition process according to any one of the claims 1 to 5, characterized in that the substrate (6) is a monocrystalline semiconductor material.

7. Deposition process according to any one of the claims 1 to 6, characterized in that the substrate (6) is made from silicon or a III—V material.

8. Deposition process according to any one of the claims 1 to 7, characterized in that the substrate (6) is heated at a temperature between 600 and 800°C.

9. Deposition process according to any one of the claims 1 to 8, characterized in that the molecular flux (13) of said material (16) is formed by the irradiation of a target of said material with an electron beam (22).

10. Deposition process according to any one of the claims 1 to 9 for several layers of the same material doped in different ways, characterized in that the intensity of the electron beam (28) and/or the doping particle beam is suddenly modified.